# EUROPEAN PATENT APPLICATION

(11) **EP 3 142 143 A1**
(43) Date of publication of application: **15.03.2017**
(21) Application number: 15184786.0
(22) Date of filing: 11.09.2015
(51) Int. Cl.: H01L 21/329, H01L 29/861, H01L 29/06, B23K 26/364, H01L 21/784

(54) **METHOD FOR MANUFACTURING A POWER SEMICONDUCTOR DEVICE**

(71) Applicant: ABB Technology AG, 8050 Zürich (CH)
(72) Inventor: Vobecky, Jan, 5600 Lenzburg (CH); Stiegler, Karlheinz, 5702 Niederlenz (CH); Dobrzynska, Jagoda, 5702 Niederlenz (CH); Bellini, Marco, 8952 Schlieren (CH)
(74) Representative: ABB Patent Attorneys

(57) **Abstract**

A method for manufacturing a power semiconductor device having an active region and a termination region surrounding the active region is provided. For the creation of a junction termination in the termination region the following steps are performed:
(a) providing a substrate (1) of a first conductivity type having a first side (10) and a second side (15),
(b) applying a masking layer (2, 20) on the first and on the second side (10, 15),
(c) then creating a first recess (3) on the first side, and
(d) creating a second recess (4) on the second side (15), the minimum substrate thickness (12) between the first recess (3) and the second recess (4) being thick enough to provide mechanical stability for the following manufacturing steps,
(e) after step (d) applying a first dopant (50, 550) of a second conductivity type on the first side and on the second side (10, 15), wherein the first dopant is absorbed in the masking layer (2, 20),
(f) creating a first layer (5) by driving-in the first dopant in the first recess (3) and a second layer (55) by driving-in the first dopant in the second recess (4), wherein the first layer (5) and the second layer (55) form a continuous layer between the first recess (3) and the second recess (4) and
wherein in step (d) the minimum substrate thickness (12) is so small that in step (f) the first layer (5) and the second layer (55) can form the continuous layer.

## Description

### Technical Field

The invention relates to the field of power electronics and more particularly to a semiconductor device according to the preamble of claim 1.

### Background Art

Prior art reverse blocking (RB) devices with two blocking p-n junctions such as RB-thyristors or RB-IGBTs comprise in a wafer having a first and a second side a central region, which is the electrically active region, and a termination region surrounding the central region. In the termination region the reverse blocking capability is achieved by having a p doped layer, which extends from the first to the second side and thereby connects the p doped layer from the second side to an area on the first side.

In EP 1 394 860 A2 such a prior art power semiconductor device is described having in the termination region a p doped layer, which has been diffused from both sides into the wafer. This method for establishing the p doped layer needs very long diffusion times for the deep p layer and is therefore practically limited to be applied on thin wafers. For a deposition of Al and afterwards diffusion of Al in a clean environment, i.e. in clean room compatible way, into a depth of 90 µm a time of 38 h is needed and into a depth of 120 µm, already 48 h are needed and into 140 µm 65 h. For greater depths, the diffusion is even more slowed down, it saturates, i,e, nearly stops. Al is preferred as dopant because of its quicker diffusion time than other dopants like Boron. Therefore, this process is practically limited to about 1600 V devices. For deeper diffusions required for higher voltage classes (1.8, 2.5 and 3.3 kV), Al can be deposited from a metal surface layer, which is however not compatible with standards for cleanliness in semiconductor industry. As by the long diffusion time, the p dopant is also laterally spread wide, a wide layer is created, needing unadvantageously much lateral space.

N. Tokuda et al, "An ultra-small isolation area for 600V class Reverse Blocking IGBT with Deep Trench Isolation process (TI-RB-IGBT)", Proceedings of 2004 ISPSD, Kitakyushu, pp.129 - 132, try to reduce the time for creating such a p doped junction termination by having a p+ doped substrate, on which a 110 µm thick n- doped epitaxial layer is grown. A deep and narrow trench of less than 15 µm width is etched through the whole n- epitaxial layer to the p+ substrate. Into this narrow trench, Boron is implanted at an extremely low incident angle. This method has the advantage of needing little lateral space for the creation of the p doped termination layer, but is limited for larger device thickness due to the difficulty of implanting the p dopant into the narrow and deep trench. As the trench is etched down to the p+ substrate, the semi-fabricated chip is fragile and handling of the chip for further processing is difficult. Due to the depth limits for etching the narrow trench, this method may be applied for devices up to 1200 V. It is very difficult to achieve a uniform doping concentration by the Boron implant and due to these difficulties, the reproducibility of the process is bad.

### Disclosure of Invention

It is an object of the invention to provide a method for producing a semiconductor device having in the termination region a junction termination extending through the substrate to connect the first and second side of the substrate.

This object is achieved by a method for manufacturing a semiconductor device according to claim 1.

For the inventive method for manufacturing a power semiconductor device having a central region and a termination region surrounding the central region between a first and a second side, the following manufacturing steps are performed for a creation of a junction termination in the termination region:
(a) providing a substrate of a first conductivity type having a first side and a second side opposite to the first side,
(b) applying a masking layer on the first side and on the second side,
(c) then creating a first recess on the first side having a first recess depth from the first side, and
(d) creating a second recess on the second side having a second recess depth from the second side, wherein a minimum substrate thickness between the first recess and the second recess being thick enough to provide mechanical stability for the following manufacturing steps,
(e) after step (c) and (d) applying a first dopant of a second conductivity type on the first side and on the second side, wherein the first dopant being absorbed in the masking layer,
(f) creating a first layer by driving-in the first dopant in the first recess and a second layer by driving-in the first dopant in the second recess, wherein the first layer and the second layer forming a continuous layer between the first recess and the second recess,
wherein in step (d) the minimum substrate thickness (12) being so small that in step (f) the first layer (5) and the second layer (55) can form the continuous layer.

Due to the introduction of the first and second recesses, an optimum balance is achieved between shorting of diffusion time for the creation of the continuous junction termination from the first to the second side, providing mechanical stability during the further manufacturing steps.

The lateral space needed for the recesses by the laser ablation process is also an optimized to achieve a uniform deposition of the first dopant without the need of sophisticated processes and for using little lateral space for the junction termination.

Further exemplary embodiments of the inventive subject matter are disclosed in the dependent claims.

### Brief Description of Drawings

The subject matter of the invention will be explained in more detail in the following text with reference to the attached drawings, in which:
- FIG 1 to 6: show a manufacturing method for the creation of a p doped junction termination in an n- doped substrate for a semiconductor device;
- FIG 7 and 8: show alternative manufacturing steps;
- FIG 9: shows a cross sectional view of an inventive diode;
- FIG 10: shows a cross sectional view of an inventive thyristor; and

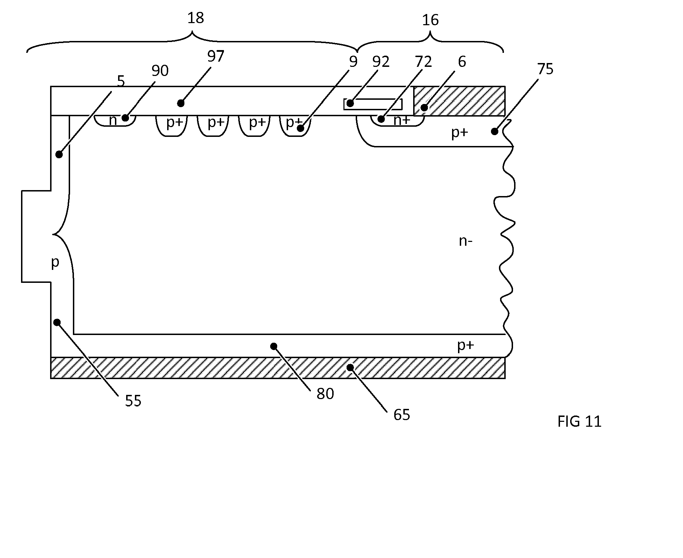

- FIG 11: shows a cross sectional view of an inventive RB-IGBT.
The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

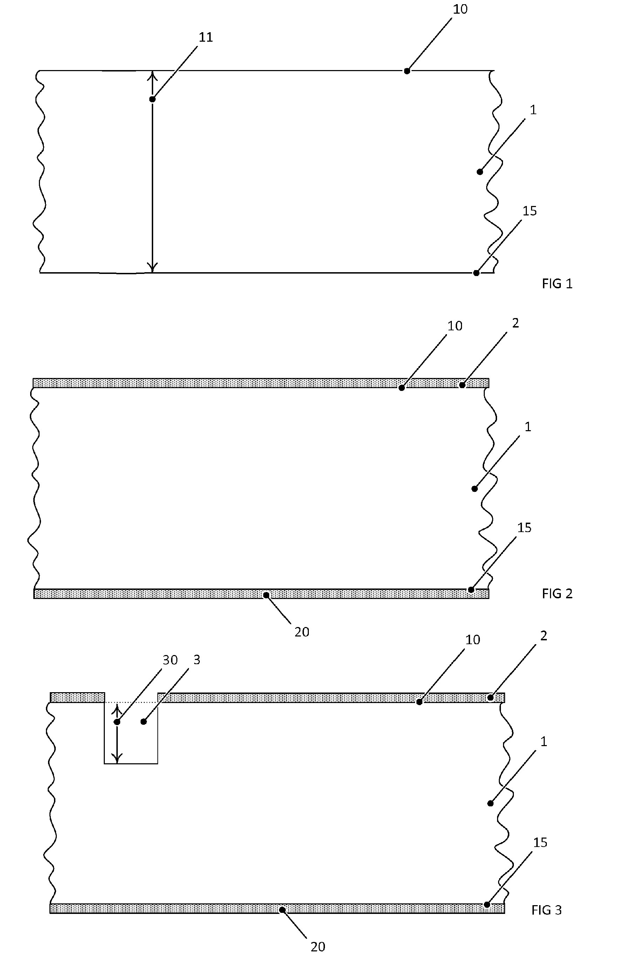

In step (a), a substrate 1 is provided having a first side 10 and a second side 15 opposite to the first side 10 (FIG 1). Exemplarily, the substrate is a silicon substrate having a substrate thickness 11 and being n- doped. The n- substrate will form in the finalized device a drift layer. The substrate 1 has a thickness between the first and the second side 10, 15 of exemplarily at least 350 µm, i.e. of a high thickness needed for high voltage devices, exemplarily for devices of 1650 V or higher thickness for higher voltage devices.

In step (b), on both sides 10 and 15 a masking layer 2, 20 is applied, which covers the first and second side 10, 15 (FIG 2). The masking layer 2, 20 is a continuous layer covering the whole surface of the substrate 1 on the first or second side 10, 15, respectively. The masking layer 2, 20 is able to absorb a first dopant later applied in a step (e) and thus, to prevent the first dopant to enter the substrate 1 behalf of the areas, in which the masking layer 2, 20 has been removed. Exemplarily, a stack of layers is used to create the masking layers 2, 20. This stack of layers may comprise at least one SiO₂ layer or a Si₃N₄ layer. Exemplarily, a combination of a SiO₂ layer, followed by a Si₃N₄ layer and again a SiO₂ layer forms a masking layer capable of efficiently absorbing the first dopant, i.e. of preventing the p first dopant in step (e) to be introduced into the substrate 1 even at high diffusion temperatures such as 1250 - 1300 °C. Such a SiO₂- Si₃N₄ - SiO₂ masking layer 2, 20 provides good mechanical stability and is insensitive to cracking. It can effectively block the diffusion of Aluminum also from other sources than ion implantation, e.g. vacuum deposition at a silicon wafer surface. Moreover, this masking layer 2, 20 stays stable during long term diffusion up to 100 hours, so that even the very high voltage devices (like 8.5 kV ones) can be diffused.

A marker may be introduced into the masking layer for improving an alignment of the first and second recess 3, 4 so that the recesses 3, 4 may be formed opposite to each other. The marker, exemplarily in the form of a hole through the substrate 1, may be made by a laser beam without any additional masking (position of the laser beam is adjusted by digital control of position at the same laser ablation tool as is used for making the recess). It is exemplarily arranged outside the area, in which the device (i.e. chip) shall be manufactured. Exemplarily, two markers are introduced into the substrate 1, e.g. by a laser beam for achieving a good alignment of the first and second recess 3, 4.

On the first side 10, in step (c) a first recess 3 is created having a first recess depth 30 from the first side 10 (FIG 3). Exemplarily, the first recess 3 is created by laser ablation. This technique allows to create steep and deep recesses. The recess 3 exemplarily has a circular, rectangular or square shape. In the later finalized device the junction termination created from the recesses 3, 4 will surround a central region 16, which is the electrically active region with the device cell.

To create the first recess 3 in the substrate 1, first the masking layer 2 is removed in the area, in which the first recess shall be arranged, and in the same step, in which the first recess .is created in the substrate 1. Exemplarily, the recess 3 created by laser ablation is about 50 to 80 µm wide, exemplarily up to 60 µm wide, and for each revolution of the laser head a recess depth of about 50 to 60 µm is achieved, i.e. for about 100 µm two laser revolutions are needed etc.

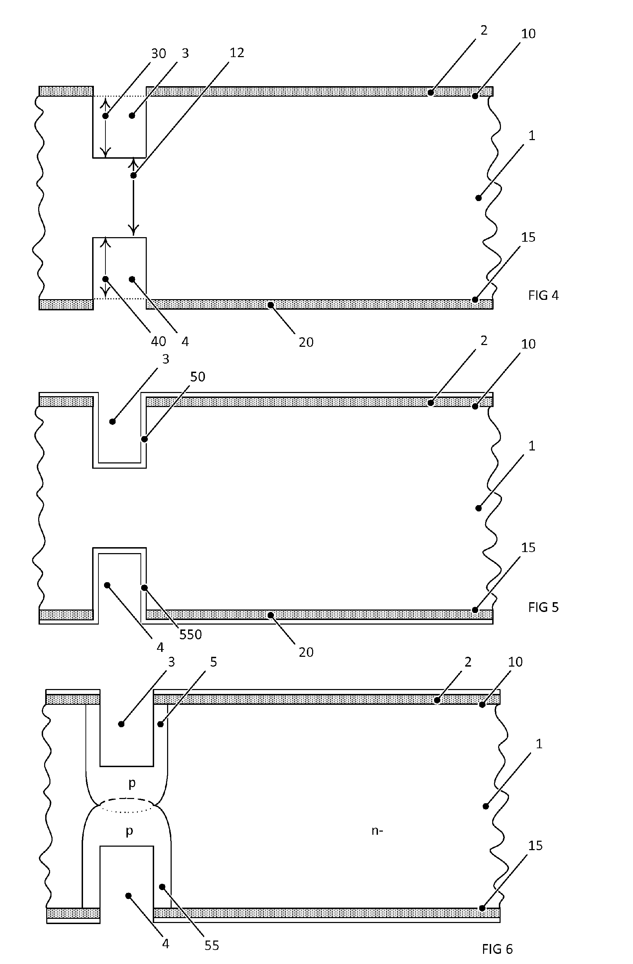

Afterwards, in step (d) the same process is performed on the second side 15, so that a second recess 4 is created having a second recess depth 40 from the second side 15 (FIG 4). Again, first the masking layer 20 is removed (e.g. by laser ablation) in the area, in which the second recess 4 shall be created, and in the same step, the second recess 4 is created by one or more laser revolutions. Exemplarily, the first and second recess have the same shape.

The first and second recesses 3, 4 exemplarily have the same depth 30, 40, but it is also possible that one of the depths 30, 40 is larger than the other depth 40, 30. The table below shows exemplary thicknesses and depths. The given values shall only be meant as exemplary values, e.g. not excluding smaller thicknesses as minimum remaining substrate thickness 12 for methods having good control of the manufacturing steps and needing a small minimum substrate thickness 12.

| Voltage class (V) | Substrate thickness 11 (µm) | First/second recess depth 30, 40 (µm) | Minimum substrate thickness 12 (µm) |
|---|---|---|---|
| 1800 | 350 - 450 | 120 - 180 | 90 - 110 |
| 2800 | 400 - 500 | 120 - 180 | 140 - 160 |
| 4200 | 600 - 750 | 240 - 300 | 120 - 150 |
| 6500 | 1000 - 1200 | 420 - 480 | 160 - 240 |
| 7500 | 1150 - 1300 | 480 - 540 | 190 - 220 |
| 8500 | 1300 - 1350 | 540 | 220 - 270 |

The first and second recess 3, 4 may be arranged opposite to each other. That shall mean that the first and second recess 3, 4 at least overlap in projection on the first side 10. Such an overlap can be used in a later optional manufacturing step to cut the substrate through in order to get separate chips from the substrate 1 and to diffuse the first dopant from the first and second recess 3, 4 such that the diffused layers overlap or at least touch each other. The minimum thickness 12 of the substrate between the first recess 3 and the second recess 4 shall be thick enough to provide mechanical stability for the following manufacturing steps. Exemplarily, the minimum thickness 12 is at least 50 µm or at least 100 µm. Such thickness is thick enough to provide mechanical stability during the further manufacturing steps. Exemplarily, the minimum substrate thickness 12 is larger for increasing voltage class (original wafer thickness) to maintain mechanical stability especially during high temperature operations.

Alternatively, the first and second recess may be laterally shifted from each other, so that the recesses 3, 4 may be created deeper. In this case, the remaining minimum substrate thickness 12 is not given in vertical direction from the first and second side 10, 15 as it is the case for the recesses being arranged opposite to each other. The minimum thickness (minimum distance between the first and second recess 3, 4) may be given in any direction, exemplarily parallel to the first and second side 10, 15. Still, this remaining thickness 12 has to fulfill the minimum thickness requirements for mechanical stability. In step (f) the diffused layers connect each other by lateral diffusion.

After having created the first and second recess 3, 4, a p first dopant is applied, exemplarily by deposition, on the first and second side 10, 15 (step (e), deposition layer 50, 550). Within the first and second recess 3, 4, the p first dopant covers the sides of the recess 3, 4. As the masking layer 2, 20 covers the surface of the substrate on the first and second side 10, 15, the p first dopant is deposited on or in the masking layer 2, 20. The masking layer 2, 20 has such absorbing properties not to let the p first dopant pass through the masking layer 2, 20 and, therefore, not to allow the p first dopant to be introduced into the substrate 1.

As a first dopant, Al may be chosen. Aluminium has a high diffusing velocity and is therefore well suited to be driven into the substrate 1. Aluminium is exemplarily driven-in at a temperature of at most 1280 or at most 1250 °C. The total diffusion time of the first dopant depends on the minimum thickness 12 of the substrate between the first and second recess 3, 4, i.e. the time needed to diffuse the first dopant to at least half the distance between the two recesses 3, 4 and thereby, to create the connected layer from the first and second 5, 55.

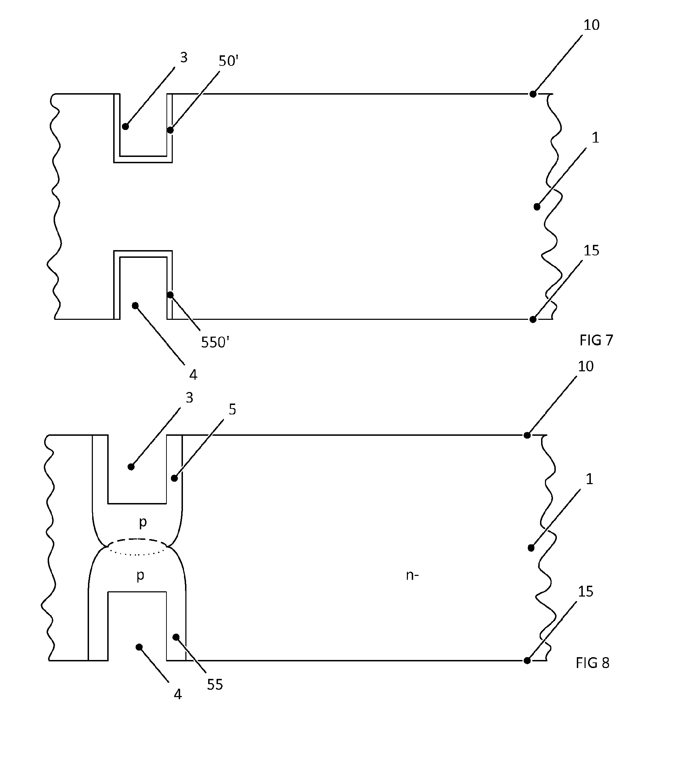

Then in step (f), the p first dopant is driven-in into the substrate to form a first layer 5 around and below the first recess 3 and to form a second layer 55 around and below the second recess 4. The first and the second layer 5, 55 have such a thickness below or around the recesses 3, 4 that the layers 5, 55 form a continuous layer from the first to the second recess 3, 4 by overlapping each other or at least touching each other (FIG 7). The first and second layer 5, 55 form a junction termination in form of a p doped sink from the first to the second side 10, 15. The diffusion time is much shorter compared to prior art processes, in which the dopant has to be diffused through the entire substrate thickness (two-sided process).

The p first dopant may be removed together with the underlying masking layer 2, 20 after the drive-in step (f) (FIG 6). In this case, there is no danger of removing the deposited Aluminum from the recess prior to drive-in together with the masking layer 2, 20.

Alternatively, the p first dopant is removed from the surface of the substrate in the regions outside the recesses 3, 4 together with the masking layer 2, 20 so that only the first dopant remains as layer 50', 550' in the first and second recess 3, 4 before the drive-in step (f) (FIG 7 and FIG 8 showing the first and second layer 5, 55 after diffusion).

The first and second layer 5, 55 may also be created by splitting the driving-in into two (or more) heating steps. First a pre drive-in may be performed, by which the first dopant is driven into the substrate 1 into an intermediate depth. In a later step (or steps) another heating ("deep drive-in") is then performed in order to diffuse the first dopant into the final first and second layer depth 30, 40. This method may be applied, if after the creation of the first and second layer 5, 55 other layers are created, which involve a heating step, by which also the first dopant is further driven into the substrate 1.

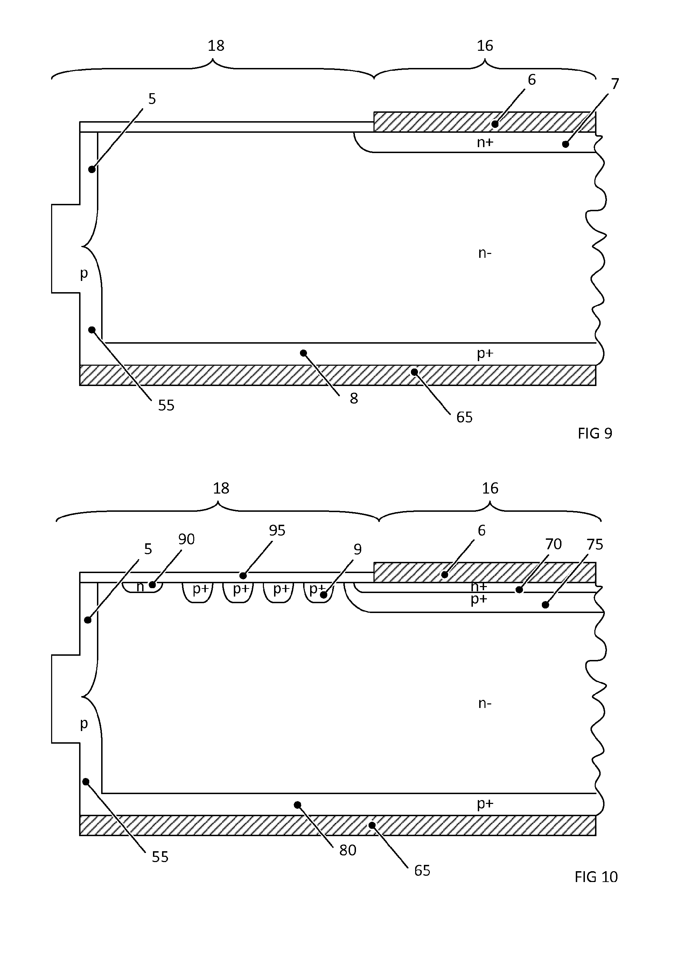

Depending on the device type, different layers may be created by applying at least one further dopant on the first and/or second side 10, 15. Exemplarily, for the creation of an inventive diode, on the first side 10 an n doped cathode layer 7 may be created in the central region 16 and on the second side 15 a p doped anode layer 8 may be created (FIG 9).

Exemplarily, for the creation of an inventive thyristor (exemplarily a phase controlled thyristor (PCT)) in the central region 16, after removal of the masking layer 2, 20 other layers may be created by on the second side 15 like a p doped anode layer 80 and on the first side 10 a p doped base layer 75 and an n doped cathode layer 70. In the termination region 18, also after the removal of the masking layer 2, 20, other layers may be created for the termination of the electric field during operation of the device like p doped guard rings 9 or an n channel stopper layer 90 on the first side 10. The n channel stopper layer 90 may be arranged between the junction termination 5, 55 and the p doped guard rings 9 (FIG 10).

The layers on the first side 10 in the termination region 18 may be covered by a passivation layer 95, exemplarily by a Diamond Like Carbon (DLC) layer or a silicon-polysilicon layer (SIPOS) or glass or a polymer. Such a passivation layer 95 may also be applied in the recesses 3, 4 on top of the diffused layers 5, 55. On top of the passivation layer 95, the passivation can be further improved by a thick layer of a silicone rubber for the case of discrete devices. For power modules, it can be passivated by silicone gel or resin or else.

Instead of guard rings the p-type region based on the VLD concept (Variation of Lateral Doping) can be used.

Exemplarily, for the creation of an inventive reverse-blocking insulated gate bipolar transistor (IGBT) in the central region 16, after removal of the masking layer 2, 20 a p doped anode layer 80 and on the first side 10 a p doped base layer 75 and an n doped source layer 72 surrounded by the p base layer 75. A gate electrode 92 is insulated from any doped layer (i.e. n source layer 72, p base layer 75 and n- drift layer, which is the part of the substrate having the low original doping concentration of the substrate 1) by an insulating layer 97, exemplarily a SIPOS layer. Further layers in the termination region 18 may be added like p guard rings 9 and n channel stopper 90.

The p doped layers 8, 80, 9, 75 may be created by applying as further dopant a second dopant different from the first dopant as p dopant. Such a second dopant may exemplarily be Boron, which has a lower drive-in speed than Aluminum. This enables the device to have a junction termination by the overlapping first and second layer 5, 55 and a shallow p collector layer 80 and p base layer 75 and guard rings 9. For the case that the second dopant is applied after the pre-drive-in of the first dopant, the diffusion time of the second dopant adds to the diffusion time of the first dopant, i.e. the diffusion time of the second dopant leads to a deep drive-in of the first dopant.

Alternatively to the other layers being created after the first and second layer 5, 55, the other layers in the central and/or termination regions 16, 18 may be created before or in between the steps for creating the junction termination 5, 55.

Finally, a first electrode 6 may be applied on the first side 10 and a second electrode 65 may be applied on the second side 15. For an inventive diode, the first electrode 6 contacts the cathode layer 7 and the second electrode 65 contacts the anode layer 8. For an inventive thyristor, the first electrode 6 contacts the source layer 70 and on the second side 15 the anode layer 80. For an inventive IGBT, the first electrode 6 contacts the source layer 72 and the p base layer 75 and on the second side 15 the anode layer 80.

After having finalized the device, the substrate 1 may be cut-through, exemplarily by a laser beam, between an area in the first recess 3 and an area in the second recess 4. For the first and second recess 3, 4 being shifted from each other, the cut is made at any appropriate place.

The process described before, may be applied for a single chip in a substrate 1, but it is also possible to create a plurality, i.e. at least two chips in one substrate 1. Further, the inventive method may, this be applied on small wafers of 3" or 4", but also on large wafers like 6" or 8 " wafers. For larger wafer, exemplarily a larger minimum substrate thickness 12 may be chosen for achieving good mechanical stability.

The inventive semiconductor device can for example be used in a power converter.

In another embodiment, the conductivity types of the layers are switched, i.e. all layers of the first conductivity type are p type (e.g. the substrate 1) and all layers of the second conductivity type are n type (e.g. the first and second layer 5, 55).

### Reference List

- 1: substrate
- 10: first side
- 11: substrate thickness
- 12: minimum substrate thickness
- 15: second side
- 16: central region
- 18: termination region
- 2, 20: masking layer
- 3: first recess
- 30: depth of first recess
- 4: second recess
- 40: depth of second recess
- 5: first layer
- 50, 550: first dopant deposition layer
- 50', 550': first dopant deposition layer in first/second recess
- 52: sink
- 55: second layer
- 6: first electrode
- 65: second electrode
- 7: cathode layer
- 70, 72: source layer
- 75: base layer
- 8, 80: anode layer
- 9: guard ring
- 90: channel stopper layer
- 92: gate electrode
- 95: passivation layer
- 97: insulating layer

## Claims

1. A method for manufacturing a power semiconductor device having a central region (16) and a termination region (18) surrounding the central region (16), wherein performing the following manufacturing steps for a creation of a junction termination in the termination region (18):
(a) providing a substrate (1) of a first conductivity type having a first side (10) and a second side (15) opposite to the first side (10),
(b) applying a masking layer (2, 20) on the first side (10) and on the second side (15),
(c) then creating a first recess (3) on the first side (10) having a first recess depth (30) from the first side (10), and
(d) creating a second recess (4) on the second side (15) having a second recess depth (40) from the second side (15), and a minimum substrate thickness (12) between the first recess (3) and the second recess (4) being thick enough to provide mechanical stability for the following manufacturing steps,
(e) after step (d) applying a first dopant (50, 550) of a second conductivity type on the first side (10) and on the second side (15), wherein the first dopant being absorbed in the masking layer (2, 20),
(f) creating a first layer (5) by driving-in the first dopant in the first recess (3) and a second layer (55) by driving-in the first dopant in the second recess (4), wherein the first layer (5) and the second layer (55) forming a continuous layer between the first recess (3) and the second recess (4),
wherein in step (d) the minimum substrate thickness (12) being so small that in step (f) the first layer (5) and the second layer (55) can form the continuous layer.

2. The method for manufacturing a power semiconductor device according to claim 1, **characterized in, that** in step (d) creating the second recess (4) opposite to the first recess (3).

3. The method for manufacturing a power semiconductor device according to claim 1 or 2, **characterized in, that** in step (a) providing the substrate (1) having a thickness (11) between the first side (10) and the second side (15) of at least 350 µm.

4. The method for manufacturing a power semiconductor device according to any of the claims 1 to 3, **characterized in, that** in step (b) providing the masking layer (2, 20) of a stack of layers comprising at least one SiO₂ layer or a Si₃N₄ layer.

5. The method for manufacturing a power semiconductor device according to any of the claims 1 to 4, **characterized in, that** at least one
in step (c) creating the first recess (3) by laser ablation or
in step (d) creating the second recess (4) by laser ablation.

6. The method for manufacturing a power semiconductor device according to any of the claims 1 to 5, **characterized in, that** after step (b) creating at least one marker for aligning the first recess (3) and the second recess (4) to each other.

7. The method for manufacturing a power semiconductor device according to any of the claims 1 to 6, **characterized in, that** in step (d) the minimum substrate thickness (12) being at least 50 µm or at least 100 µm.

8. The method for manufacturing a power semiconductor device according to any of the claims 1 to 7, **characterized in, that** in step (e) applying the first dopant by deposition.

9. The method for manufacturing a power semiconductor device according to any of the claims 1 to 8, **characterized in, that** in step (e) applying Al as the first dopant.

10. The method for manufacturing a power semiconductor device according to any of the claims 1 to 9, **characterized in, that** in step (f) performing a pre drive-in and a deep drive-in as driving-in.

11. The method for manufacturing a power semiconductor device according to claim 10, **characterized in, that** in step (f) first performing a pre-drive-in for the first dopant in the first recess (3) and the second recess (4), removing the masking layer (2, 20), then applying at least one further dopant at least on the first side (10) or on the second side (15) in an area, which has been covered by the masking layer (2, 20) after step (d) and then performing a deep drive-in for the first dopant and the further dopant.

12. The method for manufacturing a power semiconductor device according to claim 11, **characterized in, that** applying as the further dopant a second dopant of the second conductivity type different from the first dopant, wherein the second dopant having a slower drive-in speed than the first dopant.

13. The method for manufacturing a power semiconductor device according to claim 12, **characterized in, that** applying Boron as the second dopant.

14. The method for manufacturing a power semiconductor device according to any of the claims 1 to 13, **characterized in, that** after step (f) cutting-through the substrate (1) between an area within the first recess (3) and an area within the second recess (4).

15. The method for manufacturing a power semiconductor device according to any of the claims 1 to 14, **characterized in, that** in step (f) driving-in the first dopant at a temperature of at most 1280 °C.
